# EUROPEAN PATENT APPLICATION

(11) **EP 4 575 030 A1**
(43) Date of publication of application: **25.06.2025**
(21) Application number: 23219759.0
(22) Date of filing: 22.12.2023
(51) Int. Cl.: C23C 14/04, B29D 11/00, C23C 14/50

(54) **MASKING DEVICE FOR MASKING A SPECTACLE LENS PRODUCT IN A COATING DEVICE, COATING DEVICE AND METHOD FOR MANUFACTURING A SPECTACLE LENS PRODUCT**

(71) Applicant: Carl Zeiss Vision International GmbH, 73430 Aalen (DE)
(72) Inventor: MACIONCZYK, Frank, 73430 Aalen (DE)
(74) Representative: Tautz & Schuhmacher

(57) **Abstract**

A masking device (100) for masking a spectacle lens product (102) in a coating device (118) is provided. The masking device (100) includes a holder element (104) for holding the spectacle lens product (102) relative to a carrier (106) of the coating device (118). The masking device (100) also includes a supporting frame (108) being mountable or mounted on the carrier (106) of the coating device (118), where the supporting frame (108) is rotatable about a rotational axis (114) when mounted at the carrier (106) and where the supporting frame (108) at least partially surrounds the holder element (104) when mounted at the carrier (106). The masking device (100) also includes a masking stencil (110) mounted at the supporting frame (108) such that the masking stencil (110) is movable from a masking position (112) to a hiding position (116) and vice versa by rotating the supporting frame (108) around the rotational axis (114).

## Description

In some cases, the convex side of spectacle lenses used in sunglasses may be mirrored in order to adjust the optical transmission of said spectacle lenses and/or for fashion purposes. A mirror coating may be applied for providing the reflectivity, which can be achieved in a simple case by applying a thin, i. e. approx. 20 nm to about 100 nm thick, metallic layer. Coating materials may optionally comprise chrome, silver and/or aluminum. The reflective color of a metallic coating may essentially correspond to the reflective color of the chosen solid metal, whereby the coating is translucent and therefore reflects less light than comparable solid material due to its small layer thickness.

The thin coatings are applied, for example, by means of vapor deposition, such as physical vapor deposition (PVD), in a vacuum coating device on a surface of the spectacle lens product. In this coating process, the spectacle lens products are placed above a vapor source, from which the coating material is applied to the glass surfaces facing the vapor source. A large number of spectacle lens products are usually located on a calotte-shaped carrier to be placed in the vacuum chamber of the coating device. In order to achieve the same coating on all spectacle lens products at different positions of the carrier, the carrier may be rotated around its center axis during the coating process.

Surface mirror coatings on spectacle lens products for sunglasses may also be achieved using coatings based on multiple thin dielectric layers. In such a coating process, thin layers with different refractive indices are applied one after the other in the coating process, e. g. by means of PVD so that a layer stack is created. In the simplest case, a dielectric layer with a low refractive index, e. g. SiO2, is followed by a layer with a high refractive index, e. g. TiO2. While incident visible light passes through a single dielectric layer with almost no absorption, some of the light is partially reflected at the interfaces of the layers of the layer stack. With appropriate choice of layer materials and layer thicknesses, precisely defined optical interference between the reflected and transmitted partial beams of the incident light can be achieved. In this way, the in transmission and reflection of incident light can be adjusted to almost any degree. In particular, not only a reduction of reflection, but alternatively a highly reflective coating, i. e. mirror-like surface coating, may be provided based on dielectric coatings.

A mirror coating, which is made up of individual dielectric layers, normally has a defined reflective color after production, e. g. red, blue, green, etc. The reflective color is determined by the structure of the layer stack, the thickness of the individual layers and their refractive index. If the thickness of an individual layer of the layer stack is changed, the reflective color can also be changed. This is described, for example, in patent specification DE102012013683B.

Moreover, spatial structures can be created in reflective coatings for spectacle lens products. In a simple case, this can be achieved by manually covering a part of the lens surface before applying a coating, e. g. by means of a so-called tampo printing process or pad printing process. In this process, a pattern is printed onto the uncoated spectacle lens product using a stamp and stamping ink.

A reflective coating is then applied to the partially covered spectacle lens product. If the covering, e. g. the stamping ink, is removed from the spectacle lens product after the coating process, a pattern corresponding to the applied covering appears on the spectacle lens product as a shadow image of the cover.

The patterns produced on spectacle lens products using the covering process described above may show a monochromatic mirror layer on the parts of the lens surface that were not covered. In order to obtain two-colored mirror patterns, the tampo print or the cover, must be applied to a coating previously applied to the spectacle lens product, which may have a different color than the mirror layer applied after the tampo print or applied cover. In this case, two coating processes in vacuum are required, whereby between the two coating processes in vacuum the tampo print pattern has to be applied. In order to do so, the spectacle lens products must be removed from the coating systems so that the pattern can be applied to the spectacle lens product outside the coating systems using the tampo printing process. The document US2014/0055743A1 describes a method including the removal of an applied cover in a wet etching process, for which the spectacle lens product is removed from the vacuum.

When removing the tampo print ink after coating, e. g. by rubbing off the ink with solvent and a wiping cloth, the coating may be damaged on the uncovered glass parts, which may lead to failure of the spectacle lens product.

The document EP 3 296 423 A1 describes a vacuum coating apparatus comprising a masking arrangement having a plurality of gradient sector portions. The gradient sector portions of the masking arrangement are rotatable around the axis of rotation of the substrate holder to move the gradient sector portion from a gradient mask open position to a gradient mask closed position. The gradient sector portions are adapted to carry multiple gradient shields. Thus, when bringing a gradient sector portion to a gradient mask closed position multiple substrates may be collectively affected by the gradient sector portion. Moreover, the need for bringing the gradient sector mask to a gradient sector mask open position has the disadvantage that effectively usable space in the coating device for coating substrates is diminished by the space consumed by the gradient sector masks stored in the open position. In view of EP 3 296 423 A1 as closest prior art the objective technical problem of the claimed subject-matter may relate to facilitating a process for efficiently applying a coating to a surface of one or more individual spectacle lens product in a vacuum chamber.

This problem is solved by a masking device, a coating device, and a method for manufacturing a spectacle lens product having the features of the respective independent claim. Optional embodiments are provided in the dependent claims and the description.

In one aspect, a masking device for masking a spectacle lens product in a coating device is provided. The masking device includes a holder element for holding the spectacle lens product relative to a carrier of the coating device. The masking device also includes a supporting frame being mountable or mounted on the carrier of the coating device, where the supporting frame is rotatable about a rotational axis when mounted at the carrier and where the supporting frame at least partially surrounds the holder element when mounted at the carrier. The masking device further includes a masking stencil mounted at the supporting frame such that the masking stencil is movable from a masking position to a hiding position and vice versa by rotating the supporting frame around the rotational axis.

Moreover, a coating device for coating one or more spectacle lens products by vapor deposition is provided. The coating device includes a vacuum chamber including a vapor source for at least partially coating the one or more spectacle lens products by vapor deposition, and a carrier having multiple mounting slots. The coating device also includes multiple masking devices according to the disclosure, where one masking device of the multiple masking devices is mounted in each one of the multiple mounting slots of the carrier. Furthermore, the coating device comprises one or more force generators for applying a force to the one or more supporting frames of the multiple masking devices to rotate the one or more supporting frames about their respective rotational axis such as to switch the masking stencils of the one or more masking devices from the hiding position to the masking position or vice versa.

In addition, a method for manufacturing a spectacle lens product is provided. The method includes arranging the spectacle lens product mounted on a carrier in a vacuum chamber and evacuating the vacuum chamber, applying a first coating to a surface of the spectacle lens product by vapor deposition while a masking stencil is mounted in a hiding position, and moving a masking stencil to a masking position and applying a second coating to the surface of the spectacle lens product while the masking stencil is in the masking position. Alternatively or additionally, the order may be reversed, i.e. the first coating may be applied to a surface of the spectacle lens product by vapor deposition while a masking stencil is mounted in a masking position, followed by moving the masking stencil to the hiding position and applying a second coating to the surface of the spectacle lens product while the masking stencil is in the hiding position.

The carrier may be a carrier for supporting spectacle lens products during a coating process in vacuum. The carrier may be calotte-shaped, which means that the shape of the carrier may follow the shape of a calotte. Hence, the carrier may be domed, wherein the dome may have the shape of a half sphere or any other portion of a sphere having the shape of a spherical cap or spherical dome. The carrier may have the appearance of a spherical cap but may deviate from the strict mathematical shape of a spherical cap. The carrier may be rotationally symmetric around the central axis, wherein the central axis may form a central axis of a sphere defining the spherical cap describing the shape of the carrier. The calotte-shape of the carrier may have a radius of curvature in the range from 0,5 m to 2 m and in particular a radius of curvature in the range from 0,5 m to 1 m, i. e. the sphere describing the shape of the calotte holder may have a radius of curvature in the range from 0,5 m to 2 m and in particular a radius of curvature in the range from 0,5 m to 1,2 m or 0,8 m to 1,2 m. In case the radius of curvature varies for different altitudinal positions of the calotte-shaped carrier, the radius of curvature may be in the specified range at any position. In other words, any radius of curvature which the carrier exhibits may be well in the specified range. The carrier may be adapted to receive multiple spectacle lens products, such as 100 spectacle lens products or more.

The coating device may be a device for receiving a carrier for coating one or more spectacle lens products supported by said carrier. The coating device may be adapted to coat one or more spectacle lens products by vapor deposition.

The coating device may comprise a vacuum chamber for receiving the carrier and for storing the carrier in vacuum during the coating process.

The hiding position may be a position, in which the masking stencil may be arranged in order not to block the application of a coating to a surface of the spectacle lens product. The hiding position may optionally be located at an opposite side of the spectacle lens product relative to a vapor source used for applying the coating.

The holder element may be a mechanical element which may be attached to the spectacle lens product in order to arrange the spectacle lens product at the carrier. The holder element may be adapted to be fixed to a mounting slot of the carrier in such a manner that it prevents a relative movement of the holder element with respect to the carrier.

The masking device may refer to a device for providing a mask for altering the coating process and the resulting coating of a surface of the spectacle lens product. The masking device may be adapted to selectively arrange a masking stencil for altering a coverage of the coating applied to a surface of the spectacle lens.

The masking stencil may be a stencil defining one or more areas, in which a coating is applied to the spectacle lens product and one or more other areas, in which no coating is applied. The masking stencil may comprise parts blocking the vapor used for applying the coating. The masking stencil may comprise one or more recesses allowing the vapor used for coating to penetrate the masking stencil and to provoke a coating of the surface of the spectacle lens product in such areas, which may correspond to the one or more recesses of the masking stencil.

The mounting slot may be a slot in the carrier which is predetermined for mounting a spectacle lens product. Mounting slots may be such slots formed in the carrier which are adapted to receive a spectacle lens product in a manner to expose at least one surface of the spectacle lens product for the coating process. Each of the mounting slots may comprise a hole in the carrier on which a substrate may be placed, such that the coating may be applied to the surface through the hole in the substrate holder. The hole of the mounting slot may be adapted to support the spectacle lens product at the edge or rim of the spectacle lens product while exposing a central region of the spectacle lens product to be accessible for the coating process.

The spectacle lens product may refer to a finished spectacle lens, a semi-finished spectacle lens, a lens blank and/or a substrate for manufacturing a lens blank or a spectacle lens and may in particular meet requirements specified in EN ISO 13666:2012. A substrate for a spectacle lens may be an optical substrate for manufacturing a spectacle lens from the substrate. The spectacle lens product may have suitable dimensions for manufacturing one spectacle lens from one spectacle lens product. The spectacle lens product may form a precursor for an optical product. Alternatively, the spectacle lens product may be an (uncut) almost finished optical product which will be finished after completion of the coating process. "Multiple substrates for spectacle lenses" can refer to multiple substrates, wherein each substrate is intended for manufacturing one spectacle lens based on the respective substrate. Throughout the disclosure, the term "spectacle lens product" may in general relate to a substrate for a spectacle lens unless explicitly specified otherwise.

The supporting frame may be a mechanical element for supporting the masking stencil and optionally the holder element. The supporting frame may be adapted to mount the holder element and possibly a spectacle lens product mounted in the holder element to the carrier. The supporting frame may be adapted to allow rotating or moving the masking stencil with respect to the spectacle lens product. "Rotating" means that the masking stencil may be moved in a rotational movement by a predetermined angle, such as for example between 100° and 300° and optionally by an angle of 180°. The rotational axis may extend in a tangential direction of the calotte-shaped surface of the carrier and/or in a plane created by the holder element and/or the supporting frame. The rotational axis may extend perpendicular to an axis extending through the evaporation source of the coating device and a center of the holder element with which the supporting frame is associated.

The disclosure provides the advantage that the masking stencil may be brought to the masking position and may be removed from the masking position within the vacuum chamber of the coating device without the need of disrupting the vacuum in the vacuum chamber. This allows applying a spatially structured reflective coating to the spectacle lens product without the disadvantages exhibited by the conventional techniques. In particular, the disclosure provides the advantage that there is no need to remove the spectacle lens product from the vacuum for changing a position of the masking stencil. Hence, the vacuum may be maintained during one or more coating processes with the masking stencil arranged in the masking position and one or more coating processes with the masking stencil being arranged in the hiding position while the vacuum is maintained. This allows for an increase in the efficiency of the coating process and reducing a required time for completing the coating process. Moreover, this results in a higher energy efficiency as it does not require venting and re-evacuating the vacuum chamber.

In addition, the disclosure provides the advantage that no masking layers have to be applied to and removed from the spectacle lens product. This allows for reducing the required manual work for the masking process and avoid a risk of damaging the spectacle lens product due to mechanical and/or chemical treatment. Moreover, the disclosure provides the advantage that the use of chemicals is not required for the masking process and, thus the masking process may be carried out in a more ecological manner.

Moreover, the disclosure provides the advantage that for each spectacle lens product and individual masking stencil may be provided and that for each spectacle lens product the masking stencil may be individually movable.

This may allow combining spectacle lens products in the coating device with and without a need for applying coatings using an individual masking stencil.

In addition, the disclosure may provide the advantage that no coating area has to be sacrificed in the vacuum chamber for storing the masking stencils in their hiding position. Since the masking stencils may be moved into their hiding position by rotating the masking stencils behind their respective spectacle lens product, i.e. to a side of the spectacle lens product facing away from the evaporation source, there is no need to reserve a part of the area in the coating device which may otherwise be used for coating further spectacle lens products. Accordingly, the coating device may be used in a more efficient manner than when using a masking technique as described in EP 3 296 423 A1.

The masking device may be adapted such that the masking stencil at least partially obscures a spectacle lens product mounted in the holder element with respect to a vapor source of the coating device when arranged in the masking position, and such that the masking device does not obscure the spectacle lens product mounted in the holder element with respect to the vapor source of the coating device when arranged in the hiding position. This may provide the advantage that the entire surface of the spectacle lens product may be coated when the masking stencil is arranged in the hiding position and to apply a spatially selective coating according to the masking stencil when the masking stencil is arranged in the masking position.

The masking device may have a geometrical shape allowing for moving the masking stencil around the holder element when rotating the supporting frame about the rotational axis. In other words, the masking stencil and the holder element may be adapted such that the holder element and/or the spectacle lens product mounted in the holder element does not block the masking stencil when the supporting frame rotates about the rotational axis.

The supporting frame may be ring-shaped and may span an area for receiving the holder element and a spectacle lens product held by the holder element. The supporting frame may be adapted to be attached to a mounting slot of the carrier.

The holder element may be ring-shaped and adapted to be mountable in the area spanned by the supporting frame. Moreover, the ring-shaped holder element may have a circular footprint, wherein the masking stencil may have a shape based on a spherical cutout and/or a spherical segment. A circular footprint may refer to a circular shape in a plane, in which the holder element may be received by the carrier. The holder element may have a flat profile in a direction perpendicular to an extension of a mounting slot of the carrier. The shape of the masking stencil being based on a spherical cutout and/or a spherical segment may be well suited for moving the masking stencil around the ring-shaped holder element when rotating the supporting frame while still keeping the required space for the rotational movement limited.

The masking stencil may have one or more recesses providing a spatially dependent cover for the spectacle lens product mounted in the holder element when the masking stencil is arranged in the masking position. This allows for applying a spatially selective coating to the spectacle lens product according to the one or more recesses without the need of applying chemicals or venting and re-evacuating the vacuum chamber.

The supporting frame may be rotatable about the rotational axis by applying a magnetic force to the supporting frame and/or to the masking stencil. This allows rotating the supporting frame and the masking stencil without a need of directly mechanically contacting the supporting frame and/or the masking stencil. Moreover, this may allow using a magnetic force generator, such as a permanent magnet, which may be provided inside the vacuum chamber for other purposes.

The carrier may be adapted as a calotte-shaped carrier for carrying multiple masking devices to allow coating multiple spectacle lens products, wherein each spectacle lens product of the multiple spectacle lens products may be mounted in one of the masking devices. This allows coating several spectacle lens products with spatially selective reflective coatings in coating process, i. e. in one process between evacuating and venting the vacuum chamber.

The step of arranging the spectacle lens product in the vacuum chamber of the method according to the disclosure may comprise mounting the spectacle lens product in a holder element, wherein the holder element is at least partially surrounded by a supporting frame mounted on a carrier of the coating device, and wherein the supporting frame is rotatable about a rotational axis. Moreover, the step of arranging the spectacle lens product in the vacuum chamber may comprise arranging the holder element and the supporting frame on the carrier of the coating device and arranging the carrier in the vacuum chamber of the coating device. The vacuum chamber may remain evacuated while and between applying the first coating and applying the second coating.

Other technical features may be readily apparent to one skilled in the art from the following figures, descriptions, and claims.

It is understood by a person skilled in the art that the above-described features and the features in the following description and figures are not only disclosed in the explicitly disclosed embodiments and combinations, but other technically feasible combinations as well as the isolated features are comprised by the disclosure as well. In the following, several optional embodiments and specific examples are described with reference to the figures for illustrating the disclosure without limiting the disclosure to the described embodiments.

Further optional embodiments will be illustrated in the following with reference to the drawings.

The figures show:
Figures 1A and 1B schematically depict a masking device according to an optional embodiment.
Figure 2 schematically shows a coating device according to an optional embodiment.
FIG. 3A schematically illustrates a masking stencil according to an optional embodiment.
FIG. 3B schematically presents a holder element according to an optional embodiment.
FIG. 3C schematically illustrates a spectacle lens product according to an optional embodiment.
FIG. 4 illustrates a method 400 for manufacturing a spectacle lens product in accordance with an optional embodiment.

In the drawings the same reference signs are used for corresponding or similar features in different drawings.

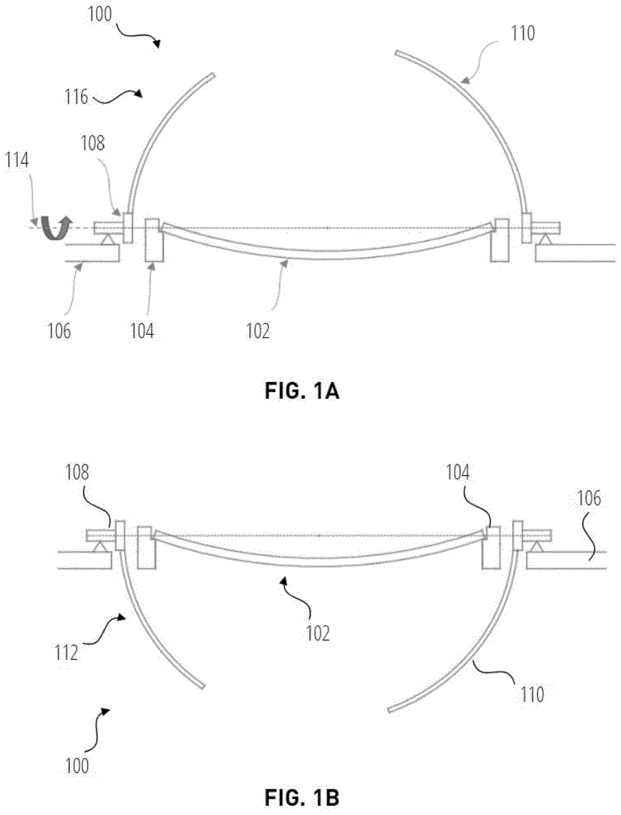

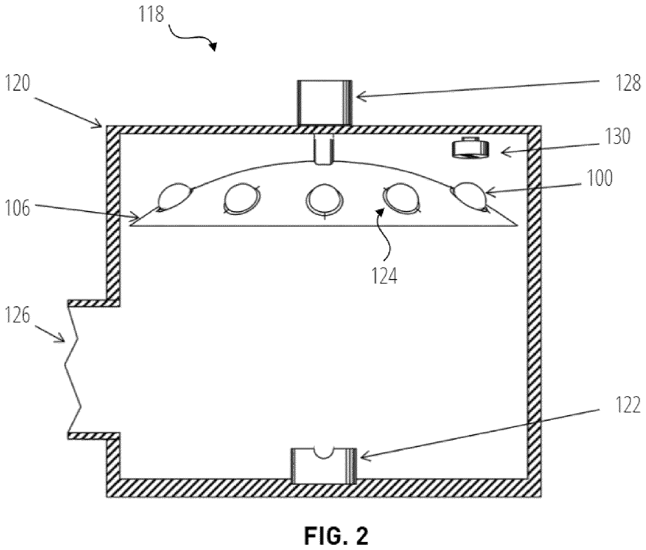

Figures 1A and 1B schematically depict a masking device 100 according to an optional embodiment for masking a spectacle lens product 102 in a coating device 118 (see Figure 2). The masking device 100 comprises a holder element 104 for holding the spectacle lens product 102 relative to a carrier 106 of the coating device 118, and a supporting frame 108 being mountable or mounted on the carrier 106 of the coating device 118, wherein the supporting frame 108 is rotatable about a rotational axis 114 when mounted at the carrier 106 and wherein the supporting frame 108 at least partially surrounds the holder element 104 when mounted at the carrier 106. The masking device 100 further comprises a masking stencil 110 mounted at the supporting frame 108 such that the masking stencil 110 is movable from a masking position 112, as shown in Figure 1B, to a hiding position 116, as shown in Figure 1A, and vice versa by rotating the supporting frame 108 around the rotational axis 114. A vapor source 122 of the coating device 118 may be arranged below the spectacle lens product 102. Accordingly, when the masking stencil 110 is arranged above the spectacle lens product 102, it is arranged in a hiding position 116, since the masking stencil 110 does not affect the coating of the spectacle lens product 102 during the coating process. The masking device 100 is inserted into a mounting slot 124 of the carrier 106, wherein the dimensions and/or shape of the supporting frame 108 may be adapted to the size and/or shape of the mounting slot 124.

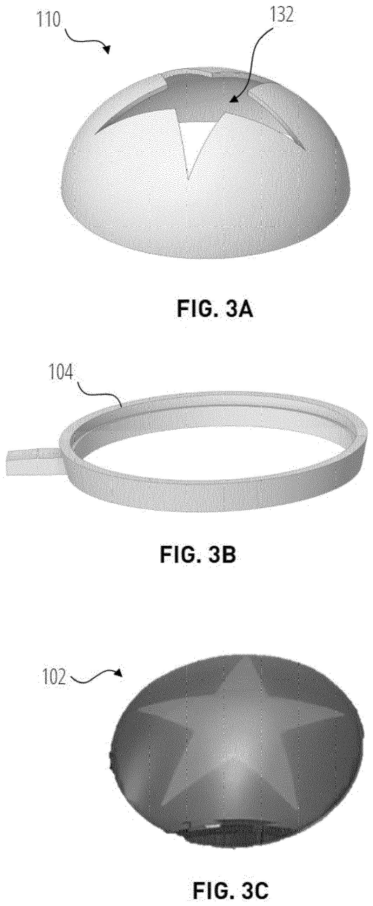

Figure 1B shows the masking device 100 of Figure 1A after rotating the supporting frame 108 from the hiding position 116 to the masking position 112. In this masking position 112, the masking stencil 110 may affect the coating of the front surface of the spectacle lens product 102 (lower surface in Figures 1A and 1B) by vapor provided by a vapor source 122 below the spectacle lens product 102. The masking stencil 110 may have one or more recesses 132 (see Figure 3A) to provide a spatially dependent coating of the front surface of the spectacle lens product 102, wherein the spatially dependent coating may be determined by the size and shape of the one or more recesses 132 of the masking stencil 110.

The masking device 100 may be adapted such that the masking stencil 110 at least partly obscures the spectacle lens product 102 mounted in the holder element 104 with respect to a vapor source 122 (see FIG. 2) of the coating device 118 when arranged in the masking position 112, and such that the masking device 100 does not obscure the spectacle lens product 102 mounted in the holder element 104 with respect to the vapor source 122 of the coating device 118 when arranged in the hiding position 116.

The masking stencil 110 may have a geometrical shape allowing to move the masking stencil 110 around the holder element 104 when rotating the supporting frame 108 about the rotational axis 114.

The supporting frame 108 may be ring-shaped and may span an area for receiving the holder element 104 and a spectacle lens product 102 held by the holder element 104.

The holder element 104 may be ring-shaped and adapted to be mountable in the area spanned by the supporting frame 108.

The ring-shaped holder element 104 may have a circular footprint and the masking stencil 110 may have a shape based on a spherical cutout and/or a spherical segment.

The masking stencil 110 may have one or more recesses 132 providing a spatially dependent cover for the spectacle lens product 102 mounted in the holder element 104 when the masking stencil 110 is arranged in the masking position 112.

The supporting frame 108 may be rotatable about the rotational axis 114 by applying a magnetic force to the supporting frame 108 and/or to the masking stencil 110.

Figure 2 schematically shows a coating device 118 according to an optional embodiment. The coating device 118 is adapted to coat one or more spectacle lens products 102 by vapor deposition. The coating device 118 comprises a vacuum chamber 120 including a vapor source 122 for at least partially coating the one or more spectacle lens products 102 by vapor deposition. The coating device 118 further comprises a carrier 106 having multiple mounting slots 124. Moreover, the coating device 118 further comprises multiple masking devices 100 which may optionally correspond to the embodiment shown in FIG. 1A and FIG. 1B., wherein one masking device 100 of the multiple masking devices 100 is mounted in each one of the multiple mounting slots 124 of the carrier 106. In addition, the coating device 118 further comprises one or more force generators 130 for applying a force to the one or more supporting frames 108 of the multiple masking devices 100 to rotate the one or more supporting frames 108 about their respective rotational axis 114 such as to switch the masking stencils 110 of the one or more masking devices 100 from the hiding position 116 to the masking position 112 or vice versa.

The coating device 118 may be adapted to rotate the one or more supporting frames 108 about their respective rotational axis 114 within the evacuated vacuum chamber 120.

The coating device 118 may be adapted as a calotte-shaped carrier 106 for carrying multiple masking devices 100 to allow coating multiple spectacle lens products 102, wherein each spectacle lens product 102 of the multiple spectacle lens products 102 may be mounted in one of the masking devices 100.

The coating device 118 may be adapted to coat one or more spectacle lens products 102 by vapor deposition.

In addition, the coating device 118 shown in FIG. 2 further illustrates the vapor source 122, which is adapted to provide a vapor of the one or more materials, which shall form the coatings to be applied to the surface of the spectacle lens product 102 facing the vapor source 122.

Moreover, the coating device 118 comprises an opening 126 for evacuating the vacuum chamber 120, and a drive unit 128 for rotating the carrier 106 about a vertical axis. In addition, the coating device 118 comprises a force generator 130 for rotating the supporting frames 108 about their respective rotational axis 114 in order to move the respective masking stencils 110 from their hiding position 116 to the masking position 112 and vice versa. The force generator 130 may include one or more magnetic elements, which may include one or more permanent magnets and/or electrical magnets, in order to apply a magnetic force to the supporting frame 108 and/or the masking stencil 110 in order to rotate the supporting frame 108 and the masking stencil 110 from the hiding position 116 to the masking position 112 and/or vice versa.

FIG. 3A schematically illustrates a masking stencil 110 according to an optional embodiment. The masking stencil 110 has a geometrical shape corresponding to a hemisphere or a dome, which allows rotating the masking stencil 110 around a ring-shaped holder element 104, as for instance presented in FIG. 3B. The masking stencil 110 comprises a star-shaped recess 132, which allows applying a spatially dependent coating to the spectacle lens product 102 partially covered by the masking stencil 110 in the shape of a star.

FIG. 3B schematically presents a holder element 104 according to an optional embodiment. The holder element 104 is ring-shaped and adapted to receive a spectacle lens product 102 and to fixate the spectacle lens product 102 with respect to a carrier 106 of a coating device 118. The holder element 104 may be adapted to immobilize the spectacle lens product 102 with respect to the carrier 106. The holder element 104 may be adapted such that the spectacle lens product 102 remains immobilized when the supporting frame 108 is rotated about its rotational axis 114 in order to bring the masking stencil 110 from the hiding position 116 to the masking position 112 or vice versa. However, optionally the holder element 104 may be adapted to allow rotating the holder element 104 about the rotational axis 114, too. In this case, for rotating the holder element 104 a different force generator may be used and/or the same force generator 130 used for rotating the supporting frame 108 may be used.

FIG. 3C schematically illustrates a spectacle lens product 102 having a spatially dependent reflective coating on its front surface, wherein the spatially dependent reflective coating has the shape of a star. Such a spatially dependent coating may be applied by using a masking device 100 as described with reference to FIG. 1A and FIG. 1B and with a masking stencil as presented in FIG. 3A.

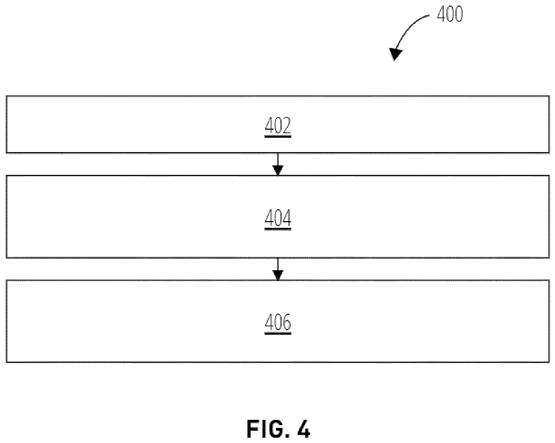

With reference to FIG. 4, a method 400 according to an optional embodiment for manufacturing a spectacle lens product 102 is described.

In method step 402, method 400 arranges the spectacle lens product 102 mounted on a carrier 106 in a vacuum chamber 120 and evacuating the vacuum chamber 120. Method step 402 may comprise mounting the spectacle lens product 102 in the holder element 104, wherein the holder element 104 may be at least partially surrounded by a supporting frame 108 mounted on a carrier 106 of the coating device 118, and wherein the supporting frame 108 is rotatable about a rotational axis 114. Moreover, method step 402 may comprise arranging the holder element 104 and the supporting frame 108 on the carrier 106 of the coating device 118 and arranging the carrier 106 in the vacuum chamber 120 of the coating device 118.

In method step 404, method 400 applies a first coating to a surface of the spectacle lens product 102 by vapor deposition while a masking stencil 110 is mounted in a hiding position 116.

In method step 406, method 400 moves the masking stencil to a masking position 112 and applies a second coating to the surface of the spectacle lens product 102 while the masking stencil 110 is in the masking position 112.

The vacuum chamber 120 of the coating device 118 may remain evacuated while and between applying the first coating and applying the second coating.

### Listing of reference numerals

- 100: masking device
- 102: spectacle lens product
- 104: holder element
- 106: carrier
- 108: supporting frame
- 110: masking stencil
- 112: masking position
- 114: rotational axis
- 116: hiding position
- 118: coating device
- 120: vacuum chamber
- 122: vapor source
- 124: mounting slot
- 126: opening
- 128: drive unit
- 130: force generator
- 132: recesses
- 400: method
- 402: method step
- 404: method step
- 406: method step

## Claims

1. Masking device (100) for masking a spectacle lens product (102) in a coating device (118), the masking device (100) comprising:
- a holder element (104) for holding the spectacle lens product (102) relative to a carrier (106) of the coating device (118);
**characterized in that** the masking device (100) further comprises:
- a supporting frame (108) being mountable or mounted on the carrier (106) of the coating device (118), wherein the supporting frame (108) is rotatable about a rotational axis (114) when mounted at the carrier (106) and wherein the supporting frame (108) at least partially surrounds the holder element (104) when mounted at the carrier (106);
- a masking stencil (110) mounted at the supporting frame (108) such that the masking stencil (110) is movable from a masking position (112) to a hiding position (116) and vice versa by rotating the supporting frame (108) around the rotational axis (114).

2. The masking device (100) of claim 1, wherein the masking device (100) is adapted such that the masking stencil (110) at least partly obscures a spectacle lens product (102) mounted in the holder element (104) with respect to a vapor source (122) of the coating device (118) when arranged in the masking position (112), and such that the masking device (100) does not obscure the spectacle lens product (102) mounted in the holder element (104) with respect to the vapor source (122) of the coating device (118) when arranged in the hiding position (116).

3. The masking device (100) of claim 1 or 2, wherein the masking stencil (110) has a geometrical shape allowing to move the masking stencil (110) around the holder element (104) when rotating the supporting frame (108) about the rotational axis (114).

4. The masking device (100) of any one of claims 1 to 3, wherein the supporting frame (108) is ring-shaped and spans an area for receiving the holder element (104) and a spectacle lens product (102) held by the holder element (104).

5. The masking device (100) of claim 4, wherein the holder element (104) is ring-shaped and adapted to be mountable in the area spanned by the supporting frame (108).

6. The masking device (100) of claim 5, wherein the ring-shaped holder element (104) has a circular footprint and wherein the masking stencil (110) has a shape based on a spherical cutout and/or a spherical segment.

7. The masking device (100) of any one of claims 1 to 6, wherein the masking stencil (110) has one or more recesses (132) providing a spatially dependent cover for the spectacle lens product (102) mounted in the holder element (104) when the masking stencil (110) is arranged in the masking position (112).

8. The masking device (100) of any one of claims 1 to 7, wherein the supporting frame (108) is rotatable about the rotational axis (114) by applying a magnetic force to the supporting frame (108) and/or to the masking stencil (110).

9. The masking device (100) of any one of claims 1 to 8, wherein the coating device (118) is adapted to coat one or more spectacle lens products (102) by vapor deposition.

10. Coating device (118) for coating one or more spectacle lens products (102) by vapor deposition, the coating device (118) comprising:
- a vacuum chamber (120) including a vapor source (122) for at least partially coating the one or more spectacle lens products (102) by vapor deposition; and
- a carrier (106) having multiple mounting slots (124);
**characterized in that** the coating device (118) further comprises:
- multiple masking devices (100) according to any one of claims 1 to 9, wherein one masking device (100) of the multiple masking devices (100) is mounted in each one of the multiple mounting slots (124) of the carrier (106); and
- one or more force generators (130) for applying a force to the one or more supporting frames (108) of the multiple masking devices (100) to rotate the one or more supporting frames (108) about their respective rotational axis (114) such as to switch the masking stencils (110) of the one or more masking devices (100) from the hiding position (116) to the masking position (112) or vice versa.

11. The coating device (118) of claim 10, wherein the coating device (118) is adapted to rotate the one or more supporting frames (108) about their respective rotational axis (114) within the evacuated vacuum chamber (120).

12. The coating device (118) of claim 10 or 11, wherein the carrier (106) is adapted as a calotte-shaped carrier (106) for carrying multiple masking devices (100) to allow coating multiple spectacle lens products (102), wherein each spectacle lens product (102) of the multiple spectacle lens products (102) is mounted in one of the masking devices (100).

13. Method (400) for manufacturing a spectacle lens product (102), the method (400) being **characterized in** comprising:
- arranging (402) the spectacle lens product (102) mounted on a carrier (106) in a vacuum chamber (120) and evacuating the vacuum chamber (120);
- applying (404) a first coating to a surface of the spectacle lens product (102) by vapor deposition while a masking stencil (110) is mounted in a hiding position (116); and
- moving (406) the masking stencil (110) to a masking position (112) and applying a second coating to the surface of the spectacle lens product (102) while the masking stencil (110) is in the masking position (112).

14. The method (400) of claim 13, wherein the step of arranging (402) the spectacle lens product (102) in the vacuum chamber (120) comprises:
- mounting the spectacle lens product (102) in holder element (104), wherein the holder element (104) is at least partially surrounded by a supporting frame (108) mounted on a carrier (106) of the coating device (118), and wherein the supporting frame (108) is rotatable about a rotational axis (114); and
- arranging the holder element (104) and the supporting frame (108) on the carrier (106) of the coating device (118) and arranging the carrier (106) in the vacuum chamber (120) of the coating device (118).

15. The method (400) of claim 13 or 14, wherein the vacuum chamber (120) remains evacuated while and between applying the first coating and applying the second coating.
